# EUROPEAN PATENT APPLICATION

(11) **EP 4 156 510 A1**
(43) Date of publication of application: **29.03.2023**
(21) Application number: 20942935.6
(22) Date of filing: 30.06.2020
(51) Int. Cl.: H03F 3/20, H03F 1/32

(54) **SIGNAL PROCESSING METHOD AND APPARATUS**

(71) Applicant: Huawei Technologies Co., Ltd., Longgang District, Shenzhen, Guangdong 518129 (CN)
(72) Inventor: GUO, Yan, Shenzhen, Guangdong 518129 (CN); HUANG, Baoping, Shenzhen, Guangdong 518129 (CN); LI, Feng, Shenzhen, Guangdong 518129 (CN); LI, Peng, Shenzhen, Guangdong 518129 (CN); SHI, Po, Shenzhen, Guangdong 518129 (CN)
(74) Representative: Gill Jennings & Every LLP
(86) International application number: PCT/CN2020/099581
(87) International publication number: WO 2022/000341

(57) **Abstract**

A signal processing method and apparatus are provided, including: When a first radio frequency transmit channel operates in a first bandwidth, the first radio frequency transmit channel is configured to provide, for a first PA, a signal on which digital predistortion processing is performed, and a first power module is configured to provide, for the first PA, a power supply voltage of a non-envelope waveform; the first PA is configured to amplify a first signal output by the first radio frequency transmit channel; when the first radio frequency transmit channel operates in a second bandwidth, the first power module is configured to provide, for the first PA, a power supply voltage of an envelope waveform; and the first radio frequency transmit channel is configured to provide, for the first PA, a signal on which digital predistortion processing is not performed. In the foregoing solution, during bandwidth switching, an LUT required for digital predistortion processing does not need to be adjusted, and an LUT required for generating a power supply voltage of an envelope waveform does not need to be adjusted either. Therefore, fast bandwidth switching can be implemented, and non-linear distortion of an output signal of the first radio frequency transmit channel can also be reduced.

## Description

### TECHNICAL FIELD

This application relates to the field of wireless communication technologies, and in particular, to a signal processing method and apparatus.

### BACKGROUND

A radio frequency power amplifier (PA) is a very important component in a modem communication device. A main function of the radio frequency power amplifier is to amplify an input low-power signal to a rated power level specified in a communication system standard by using a direct current function, and then feed the signal into a back-end component, such as a duplexer and an antenna for wireless transmission. Due to a characteristic of hardware of the PA, the PA usually presents an excessively strong non-linear characteristic when working. The non-linear characteristic deteriorates signal transmission quality, causes problems such as non-linear distortion of a signal, and the like. Therefore, a non-linear gain of the PA may be reduced by using a digital pre-distortion (DPD) technology and an envelope tracking (ET) technology. In the DPD technology, fitting is performed on the non-linear characteristic of the PA by using a non-linear behavior model, to obtain a predistortion coefficient corresponding to the non-linear characteristic of the PA. The predistortion coefficient is stored in a predistortion coefficient lookup table (LUT). The predistortion coefficient LUT may be loaded to a DPD core, so that the DPD core has a non-linear characteristic opposite to the non-linear characteristic of the PA. When a signal passes through two modules with opposite non-linear characteristics, namely, the DPD core and the PA, the non-linear characteristics of the two modules counteract each other, to finally obtain linear output.

In the ET technology, an ET power module supplies power to a PA, and the ET power module may change based on a change in an envelope of a radio frequency signal input by the PA. When the envelope of the radio frequency signal is large, a high power supply voltage is provided, and when the envelope is small, a low power supply voltage is provided. Therefore, power consumption of the PA can be greatly reduced, and energy conversion efficiency of the PA can be significantly improved.

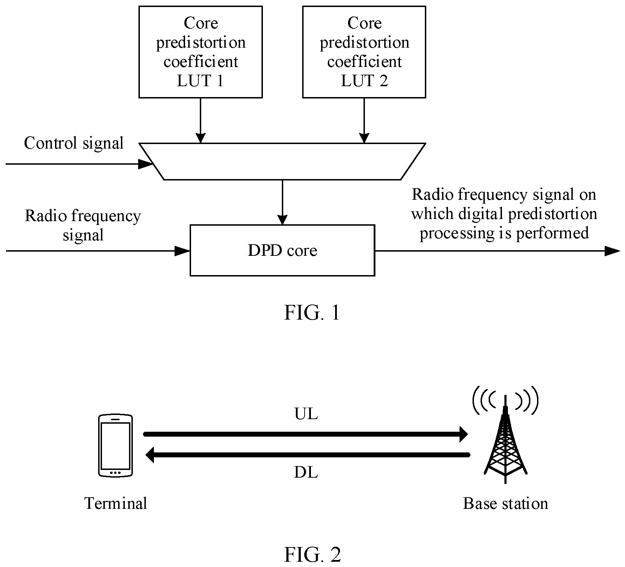

Non-linear characteristics represented by the PA in different operating conditions, such as a frequency, power, a temperature, and a bandwidth, are greatly different. When different PAs or a same PA are/is connected to different radio frequency channels, different predistortion coefficient LUTs need to be configured for the DPD core to perform adaptation. For example, as shown in FIG. 1, there are two predistortion coefficients LUTs: a predistortion coefficient LUT 1 and a predistortion coefficient LUT 2. A control signal is used when a PA operates in a bandwidth 1, to control a DPD core to load the predistortion coefficient LUT 1 corresponding to the bandwidth 1, to perform digital predistortion processing on an input radio frequency signal. When the PA operates in a bandwidth 2, the DPD core is controlled to load the predistortion coefficient LUT 2 corresponding to the bandwidth 2, to perform digital predistortion processing on an input radio frequency signal. This effectively reduces non-linear distortion of the PA.

Accordingly, the ET power module also needs to adapt to different envelope tracking LUTs based on factors such as a frequency, power, a temperature, and a bandwidth. Because a predistortion coefficient LUT in the DPD core and an envelope tracking LUT in the ET power module need to be adapted in different cases, adapting to a predistortion coefficient LUT and an envelope tracking LUT has large control overheads, but also cannot be applied to a fast radio frequency channel switching scenario. For example, a terminal needs to perform fast switching between two frequencies in one slot, for example, switching between 3.5 GHz and 2.1 GHz. For another example, in a super uplink (SU) scenario, an operating frequency of one radio frequency channel of a terminal device is controlled, based on real-time signaling, to be quickly switched between 3.5 GHz and 2.1 GHz. As described above, in this scenario, the predistortion coefficient LUT in the DPD core and the envelope tracking LUT in the ET power module need to be quickly and continuously switched between different working frequencies. The switching greatly increases an overall control load of a system. However, if the switching is not performed, efficiency of the PA decreases.

Therefore, in a fast radio frequency channel switching scenario, how to ensure working performance of the PA while ensuring fast switching between different working frequencies is an urgent problem to be resolved.

### SUMMARY

An objective of implementations of this application is to provide a signal processing method and apparatus, to improve operating performance of a PA.

It should be understood that in the solutions provided in embodiments of this application, a communication apparatus may be a wireless communication device, or may be some components in a wireless communication device, for example, an integrated circuit product such as a system chip or a communication chip. The wireless communication device may be a computer device that supports a wireless communication function.

Specifically, the wireless communication device may be a terminal such as a smartphone, or may be a radio access network device such as a base station. The system chip may also be referred to as a system on chip (SoC), or briefly referred to as a SoC chip. The communication chip may include a baseband processing chip and a radio frequency processing chip. The baseband processing chip is also sometimes referred to as a modem or a baseband chip. The radio frequency processing chip is also sometimes referred to as a radio frequency transceiver or a radio frequency chip. In a physical implementation, some or all chips of the communication chip may be integrated into the SoC chip. For example, the baseband processing chip is integrated into the SoC chip, but the radio frequency processing chip is not integrated into the SoC chip.

According to a first aspect, a communication apparatus is provided, including: a first power module and a first radio frequency transmit channel. The first radio frequency transmit channel and the first power module are separately coupled to a first power amplifier PA. When the first radio frequency transmit channel operates in a first bandwidth, the first radio frequency transmit channel is configured to provide, for the first PA, a signal on which digital predistortion processing is performed, and the first power module is configured to provide, for the first PA, a power supply voltage of a non-envelope waveform. When the first radio frequency transmit channel operates in a second bandwidth, the first radio frequency transmit channel is configured to provide, for the first PA, a signal on which digital predistortion processing is not performed, and the first power module is configured to provide, for the first PA, a power supply voltage of an envelope waveform.

According to the foregoing solution, when the first radio frequency transmit channel is switched between different bandwidths, non-linear distortion of the first PA may be reduced in different manners when the first radio frequency transmit channel operates in different bandwidths, to ensure fast bandwidth switching and reduce non-linear distortion of an output signal of the first radio frequency transmit channel. Specifically, when the first radio frequency transmit channel operates in the first bandwidth, digital predistortion processing may be performed on an input signal of the first PA, and when the first radio frequency transmit channel operates in the second bandwidth, the power supply voltage of an envelope waveform is provided for the first PA. During bandwidth switching, an LUT required for digital predistortion processing does not need to be adjusted, and an LUT required for generating a power supply voltage of an envelope waveform does not need to be adjusted either. Therefore, fast bandwidth switching can be implemented, and energy efficiency of the first PA can also be ensured.

According to a second aspect, a communication apparatus is provided, including: a first power module and a first radio frequency transmit channel. The first radio frequency transmit channel and the first power module are separately coupled to a first power amplifier PA and a third PA. When the first radio frequency transmit channel operates in a first bandwidth, the first radio frequency transmit channel is configured to provide, for the first PA, a signal on which digital predistortion processing is performed, and the first power module is configured to provide, for the first PA, a power supply voltage of a non-envelope waveform. When the first radio frequency transmit channel operates in a second bandwidth, the first radio frequency transmit channel is configured to provide, for the third PA, a signal on which digital predistortion processing is not performed, and the first power module is configured to provide, for the third PA, a power supply voltage of an envelope waveform.

According to the foregoing solution, when the first radio frequency transmit channel operates in the first bandwidth, digital predistortion processing is performed on a radio frequency signal of the first radio frequency channel, to reduce non-linear distortion. When the first radio frequency transmit channel operates in the second bandwidth, although digital predistortion processing is not performed on the radio frequency signal of the first radio frequency channel, the third PA that amplifies an output signal supplies power by using the power supply voltage of the envelope waveform, to reduce non-linear distortion. In the foregoing solution, during bandwidth switching, an LUT required for digital predistortion processing does not need to be adjusted, and an LUT required for generating a power supply voltage of an envelope waveform does not need to be adjusted either. Therefore, fast bandwidth switching can be implemented, and non-linear distortion of an output signal of the first radio frequency transmit channel can also be reduced.

In a possible design, the apparatus further includes a first digital predistortion DPD core. When the first radio frequency transmit channel operates in the first bandwidth, the first DPD core is configured to perform digital predistortion processing on a signal input to the first radio frequency transmit channel. When the first radio frequency transmit channel operates in the second bandwidth, the first DPD core is configured to be bypassed from an input end of the first PA.

In the foregoing solution, radio frequency channel linearization in an uplink high dynamic switching scenario can be implemented with minimum control overheads. In addition, the DPD core does not need to store all predistortion coefficient LUTs. In this way, linearization performance of a system and sending efficiency of the system can be improved without increasing internal storage space of the DPD core.

In a possible design, the first DPD core performs, by using a predistortion coefficient lookup table LUT corresponding to the first bandwidth, digital predistortion processing on the signal input to the first radio frequency transmit channel.

In a possible design, when the first radio frequency transmit channel operates in the second bandwidth, the first power module generates, by using an envelope tracking LUT corresponding to the second bandwidth, a power supply voltage provided for the first PA or the third PA.

In a possible design, a center frequency of the first bandwidth is different from a center frequency of the second bandwidth.

In a possible design, the center frequency of the first bandwidth is 3.5 GHz, and the center frequency of the second bandwidth is 2.1 GHz.

In a possible design, the apparatus further includes a second DPD core, a second radio frequency transmit channel, and a second PA. When the second radio frequency transmit channel operates in the first bandwidth, the second DPD core is configured to perform digital predistortion processing on a signal input to the second radio frequency transmit channel. The second radio frequency transmit channel is configured to provide, for the second PA, a signal on which digital predistortion processing is performed.

In a possible design, the apparatus further includes a second power module, where the second power module is configured to provide a power supply voltage for the second PA, and a waveform of the power supply voltage provided by the second power module is an envelope waveform.

In the foregoing solution, the second power module provides the power supply voltage of the envelope waveform for the second PA, to further reduce non-linear distortion of an output signal of the second radio frequency transmit channel, and improve system efficiency.

In a possible design, the first bandwidth is greater than the second bandwidth.

In a possible design, the first PA is located in the communication apparatus.

In a possible design, the first power module is a power module using an envelope tracking ET technology.

In a possible design, the second power module is a power module using an envelope tracking ET technology.

According to a third aspect, a method is provided, applied to a communication apparatus including a first power module and a first radio frequency transmit channel. The first radio frequency transmit channel and the first power module are separately coupled to a first power amplifier PA. The method includes: When the first radio frequency transmit channel operates in a first bandwidth, outputting, to the first PA by using the first radio frequency transmit channel, a signal on which digital predistortion processing is performed, and providing, for the first PA by using the first power module, a power supply voltage of a non-envelope waveform; and when the first radio frequency transmit channel operates in a second bandwidth, providing, for the first PA by using the first radio frequency transmit channel, a signal on which digital predistortion processing is not performed, and providing, for the first PA by using the first power module, a power supply voltage of an envelope waveform.

According to a fourth aspect, a method is provided, applied to a communication apparatus including a first power module and a first radio frequency transmit channel. The first radio frequency transmit channel and the first power module are separately coupled to a first power amplifier PA and a third PA. The method includes: When the first radio frequency transmit channel operates in a first bandwidth, providing, for the first PA by using the first radio frequency transmit channel, a signal on which digital predistortion processing is performed, and the first power module provides, for the first PA, a power supply voltage of a non-envelope waveform; when the first radio frequency transmit channel operates in a second bandwidth, providing, for the third PA by using the first radio frequency transmit channel, a signal on which digital predistortion processing is not performed; and the first power module provides, for the third PA, a power supply voltage of an envelope waveform.

In a possible design, the communication apparatus further includes a first digital predistortion DPD core; and when the first radio frequency transmit channel operates in the first bandwidth, the first DPD is used to perform digital predistortion processing on a signal input to the first radio frequency transmit channel.

In a possible design, the first DPD core performs, by using a predistortion coefficient lookup table LUT corresponding to the first bandwidth, digital predistortion processing on the signal input to the first radio frequency transmit channel.

In a possible design, a center frequency of the first bandwidth is different from a center frequency of the second bandwidth.

In a possible design, the center frequency of the first bandwidth is 3.5 GHz, and the center frequency of the second bandwidth is 2.1 GHz.

In a possible design, the communication apparatus further includes a second DPD core, a second radio frequency transmit channel, and a second PA. When the second radio frequency transmit channel operates in the first bandwidth, digital predistortion processing is performed by using the second DPD core, on a signal input to the second radio frequency transmit channel; and a signal on which the digital predistortion processing is performed is output to the second PA by using the second radio frequency transmit channel.

In a possible design, the communication apparatus further includes a second power module; and the second power module provides a power supply voltage for the second PA, and a waveform of the power supply voltage provided by the second power module is an envelope waveform.

In a possible design, the first bandwidth is greater than the second bandwidth.

In a possible design, the first PA is located in the communication apparatus.

In a possible design, the first power module is a power module using an envelope tracking ET technology.

In a possible design, the second power module is a power module using an envelope tracking ET technology.

According to a fifth aspect, a communication apparatus is provided, including: a first power module, a first power amplifier PA, and a first radio frequency transmit channel. The first radio frequency transmit channel and the first power module are separately coupled to the first PA. When the first radio frequency transmit channel operates in a first bandwidth, a waveform of a power supply voltage of the first PA is a non-envelope waveform. The first PA is configured to amplify a first signal output by the first radio frequency transmit channel, where the first signal is a signal on which digital predistortion processing is performed. When the first radio frequency transmit channel operates in a second bandwidth, the first power module is configured to provide a power supply voltage for the first PA, and a waveform of the power supply voltage provided by the first power module is an envelope waveform. The first PA is configured to amplify a second signal output by the first radio frequency transmit channel, where the second signal is a signal on which digital predistortion processing is not performed. The first bandwidth is greater than the second bandwidth.

According to a sixth aspect, a communication apparatus is provided, including: a first power module, a first power amplifier PA, a third PA, and a first radio frequency transmit channel. The first radio frequency transmit channel and the first power module are separately coupled to the first PA and the third PA, and the first PA or the third PA is configured to amplify a signal output by the first radio frequency transmit channel. When the first radio frequency transmit channel operates in a first bandwidth, the third PA is configured to be bypassed from an output end of the first radio frequency transmit channel, the first PA is configured to be connected to the output end of the first radio frequency transmit channel, and a waveform of a power supply voltage of the first PA is of a non-envelope waveform. The first PA is configured to amplify a first signal output by the first radio frequency transmit channel, where the first signal is a signal on which digital predistortion processing is performed. When the first radio frequency transmit channel operates in a second bandwidth, the third PA is configured to connect to the output end of the first radio frequency transmit channel, and the first PA is configured to bypass the output end of the first radio frequency transmit channel. The first power module is configured to provide a power supply voltage for the third PA, and a waveform of the power supply voltage provided by the first power module is an envelope waveform. The third PA is configured to amplify a second signal output by the first radio frequency transmit channel, where the second signal is a signal on which digital predistortion processing is not performed. The first bandwidth is greater than the second bandwidth.

In a possible design, the apparatus further includes a first digital predistortion DPD core. When the first radio frequency transmit channel operates in the first bandwidth, the first DPD core is configured to perform digital predistortion processing on an input signal, to obtain the first signal. When the first radio frequency transmit channel operates in the second bandwidth, the first DPD core is configured to be bypassed from the input end of the first PA.

In a possible design, the first DPD core performs digital predistortion processing on the input signal by using a predistortion coefficient lookup table LUT corresponding to the first bandwidth.

In a possible design, the first power module generates, by using an envelope tracking LUT corresponding to the second bandwidth, a power supply voltage provided for the first PA.

In a possible design, a center frequency of the first bandwidth is different from a center frequency of the second bandwidth.

In a possible design, the center frequency of the first bandwidth is 3.5 GHz, and the center frequency of the second bandwidth is 2.1 GHz.

In a possible design, the apparatus further includes a second DPD core, a second radio frequency transmit channel, and a second PA. When the second radio frequency transmit channel operates in the first bandwidth, the second DPD core is configured to perform digital predistortion processing on a signal input to the second radio frequency transmit channel, and the second PA is configured to amplify a signal on which the second DPD core performs digital predistortion processing.

In a possible design, the apparatus further includes a second power module, where the second power module is configured to provide a power supply voltage for the second PA, and a waveform of the power supply voltage provided by the second power module is an envelope waveform.

In a possible design, the first power module is a power module using an envelope tracking ET technology.

In a possible design, the second power module is a power module using an envelope tracking ET technology.

According to a seventh aspect, a method is provided, applied to a communication apparatus including a first power module and a first radio frequency transmit channel. The first radio frequency transmit channel and the first power module are separately coupled to a first PA, the first PA is configured to amplify a signal output by the first radio frequency transmit channel, and the method includes:
When the first radio frequency transmit channel operates in a first bandwidth, the first PA amplifies a first signal output by the first radio frequency transmit channel, where the first signal is a signal on which digital predistortion processing is performed, and a waveform of a power supply voltage of the first PA is of a non-envelope waveform; and when the first radio frequency transmit channel operates in a second bandwidth, the first PA amplifies a second signal output by the first radio frequency transmit channel, where the second signal is a signal on which digital predistortion processing is not performed, a power supply voltage of the first PA is provided by the first power module, a waveform of the power supply voltage provided by the first power module is an envelope waveform; and the first bandwidth is greater than the second bandwidth.

According to an eighth aspect, a method is provided, applied to a communication apparatus including a first power module, a first power amplifier PA, a third PA, and a first radio frequency transmit channel. The first radio frequency transmit channel and the first power module are separately coupled to the first PA and the third PA. The first PA or the third PA is configured to amplify a signal output by the first radio frequency transmit channel. The method includes: When the first radio frequency transmit channel operates in a first bandwidth, the third PA is configured to bypass an output end of the first radio frequency transmit channel, and the first PA is configured to connect to the output end of the first radio frequency transmit channel; the first PA amplifies a first signal output by the first radio frequency transmit channel, where the first signal is a signal on which digital predistortion processing is performed, and a waveform of a power supply voltage of the first PA is of a non-envelope waveform; and when the first radio frequency transmit channel operates in a second bandwidth, the third PA is configured to connect to the output end of the first radio frequency transmit channel, and the first PA is configured to bypass the output end of the first radio frequency transmit channel; the third PA amplifies a second signal output by the first radio frequency transmit channel, where the second signal is a signal on which digital predistortion processing is not performed, a power supply voltage of the third PA is provided by the first power module, and a waveform of the power supply voltage provided by the first power module is an envelope waveform; and the first bandwidth is greater than the second bandwidth.

In a possible design, before the first PA amplifies the first signal, the method further includes: A first digital predistortion DPD core performs digital predistortion processing on a signal input to the first radio frequency transmit channel, to obtain the first signal.

In a possible design, before the first PA amplifies the second signal, the method further includes: configuring a first digital predistortion DPD core to be bypassed from an input end of the first PA.

In a possible design, a center frequency of the first bandwidth is different from a center frequency of the second bandwidth.

In a possible design, the center frequency of the first bandwidth is 3.5 GHz, and the center frequency of the second bandwidth is 2.1 GHz.

In a possible design, the communication apparatus further includes a second DPD core and a second radio frequency transmit channel, and the second radio frequency transmit channel includes a second PA. The method further includes: When the second radio frequency transmit channel operates in the first bandwidth, the second DPD core performs digital predistortion processing on a signal input to the second radio frequency transmit channel; and the second PA amplifies a signal on which digital predistortion processing is performed by the second DPD core.

In a possible design, the communication apparatus further includes a second power module, and the method further includes: The second power module provides a power supply voltage for the second PA, and a waveform of the power supply voltage provided by the second power module is an envelope waveform.

In a possible design, the first power module is a power module using an envelope tracking ET technology.

In a possible design, the second power module is a power module using an envelope tracking ET technology.

This application further provides a communication apparatus, including a processor and a memory. The memory is configured to store program instructions. The processor is configured to execute the program instructions stored in the memory, to implement any possible method in the third aspect or the fourth aspect.

This application further provides a communication apparatus, including a processor and an interface circuit, where the interface circuit is configured to access a memory, and the memory stores program instructions. The processor is configured to: access the memory by using the interface circuit, and execute the program instructions stored in the memory, to implement any possible method in the third aspect or the fourth aspect.

This application provides a computer-readable storage medium. The computer storage medium stores computer-readable instructions. When a computer reads and executes the computer-readable instructions, a communication apparatus is enabled to perform the method in any one of the foregoing possible designs.

This application provides a computer program product. When a computer reads and executes the computer program product, a communication apparatus is enabled to perform the method in any one of the foregoing possible designs.

This application provides a chip. The chip is connected to a memory, and is configured to read and execute a software program stored in the memory, to implement the method in any one of the foregoing possible designs.

### BRIEF DESCRIPTION OF DRAWINGS

FIG. 1 is a schematic diagram of predistortion coefficient LUT switching in a conventional technology;
FIG. 2 is a schematic diagram of a structure of a wireless communication system according to an embodiment of this application;
FIG. 3 is a schematic diagram of a structure of a communication apparatus according to an embodiment of this application;
FIG. 4 is a schematic diagram of a structure of another communication apparatus according to an embodiment of this application;
FIG. 5 is a schematic diagram of a structure of a radio frequency channel according to an embodiment of this application;
FIG. 6 is a schematic diagram of a structure of another radio frequency channel according to an embodiment of this application;
FIG. 7 is a schematic diagram of a structure of another radio frequency channel according to an embodiment of this application;
FIG. 8 is a schematic diagram of a voltage waveform according to an embodiment of this application;
FIG. 9 is a schematic diagram of another voltage waveform according to an embodiment of this application;
FIG. 10 is a schematic flowchart of signal processing according to an embodiment of this application; and
FIG. 11 is a schematic flowchart of signal processing according to an embodiment of this application.

### DESCRIPTION OF EMBODIMENTS

The following further describes in detail embodiments of this application with reference to accompanying drawings.

The technical solutions in embodiments of this application may be applied to various communication systems, for example, a Long Term Evolution (LTE) system, an LTE frequency division duplex (FDD) system, and an LTE time division duplex (TDD), a 5th generation (5G) system, a new radio (NR), or the like. This is not limited herein.

The following further describes the technical solutions provided in this application with reference to the accompanying drawings and embodiments. It should be understood that a system structure and a service scenario provided in embodiments of this application are mainly intended to explain some possible implementations of the technical solutions in this application, and should not be construed as any limitation on the technical solutions in this application. A person of ordinary skill in the art may know that, as a system evolves and an updated service scenario emerges, the technical solutions provided in this application are still applicable to same or similar technical problems.

It should be understood that, in the following description of specific embodiments of the technical solutions provided in embodiments of this application, some repeated parts may not be described again, but it should be considered that the specific embodiments are mutually referenced and may be combined with each other.

In a wireless communication system, devices may be classified into devices that provide a wireless network service and devices that use a wireless network service. The devices that provide the wireless network service are devices that form a wireless communication network, and may be briefly referred to as network equipments or network elements. The network devices are typically owned by a carrier or an infrastructure provider, and are operated or maintained by these vendors. The network devices may further be classified into a radio access network (RAN) device and a core network (CN) device. The RAN device typically includes a base station (BS).

It should be understood that the base station may also sometimes be referred to as a wireless access point (AP) or a transmission reception point (TRP). Specifically, the base station may be a generation NodeB (gNB) in a 5G new radio (NR) system or an evolved NodeB (eNB) in a 4G LTE system. Base stations may be classified into a macro base station or a micro base station based on different physical forms or transmit powers of the base stations. The micro base station is also sometimes referred to as a small base station or a small cell.

The device that uses the wireless network service may be briefly referred to as a terminal. The terminal can establish a connection to the network device, and provide a specific wireless communication service for a user based on a service of the network device. It should be understood that, because the terminal has a closer relationship with the user, the terminal is also sometimes referred to as user equipment (UE) or a subscriber unit (SU). In addition, compared with a base station that is usually placed at a fixed location, the terminal usually moves along with the user, and is also sometimes referred to as a mobile station (MS). In addition, some network devices such as a relay node (RN) or a wireless router may also sometimes be considered as terminals because the network devices have a UE identity or belong to the user.

Specifically, the terminal may be a mobile phone, a tablet computer, a laptop computer, a wearable device (for example, a smartwatch, a smart band, a smart helmet, or smart glasses), other devices that have a wireless access capability, for example, an intelligent vehicle, various internet of things (IoTs) devices including various smart home devices (such as a smart meter and a smart home appliance) and smart city devices (such as a security or monitoring device and an intelligent road transportation facility), and the like.

For ease of description, the technical solutions in embodiments of this application are described in detail by using a base station and a terminal as examples in this application.

FIG. 2 is a schematic diagram of a structure of a wireless communication system according to an embodiment of this application. As shown in FIG. 2, the wireless communication system includes a terminal and a base station. Based on different transmission directions, a transmission link from the terminal to the base station is referred to as an uplink (UL), and a transmission link from the base station to the terminal is referred to as a downlink (DL). Similarly, data transmission over the uplink may be briefly referred to as uplink data transmission or uplink transmission, and data transmission over the downlink may be briefly referred to as downlink data transmission or downlink transmission.

In the wireless communication system, the base station may provide communication coverage for a specific geographical area by using an integrated or external antenna device. One or more terminals in a communication coverage area of the base station may be connected to the base station. One base station may manage one or more cells. Each cell has one identification. The identity is also referred to as a cell identity (cell ID). From a perspective of a radio resource, a cell is a combination of a downlink radio resource and an uplink radio resource (optional) that is paired with the downlink radio resource.

It should be understood that the wireless communication system may comply with a wireless communication standard in the 3rd generation partnership project (3GPP), or may comply with another wireless communication standard, for example, an 802 series (for example, 802.11, 802.15, or 802.20) wireless communication standard of the Institute of Electrical and Electronics Engineers (IEEE). Although FIG. 2 shows only one base station and one terminal, the wireless communication system may also include other quantities of terminals and base stations. In addition, the wireless communication system may further include another network device, for example, a core network device. Examples are not enumerated herein.

The terminal and the base station need to learn of configurations predefined by the wireless communication system, including a radio access technology (RAT) supported by the system and a configuration of a radio resource stipulated by the system, for example, basic configurations of a radio frequency band and a carrier. The carrier is a frequency range that complies with a stipulation of the system. The frequency range may be determined jointly based on a center frequency of the carrier (denoted as a carrier frequency) and a bandwidth of the carrier. The configurations predefined by the system may be used as a part of a standard protocol for the wireless communication system, or may be determined through interaction between the terminal and the base station. Content of a related standard protocol may be prestored in memories of the terminal and the base station, or reflected as hardware circuits or software code of the terminal and the base station.

In the wireless communication system, the terminal and the base station each support one or more same RATs, for example, 5G NR, 4G LTE, or a RAT for a future evolved system. Specifically, the terminal and the base station each use a same air interface parameter, a same coding scheme, a same modulation scheme, and the like, and communicate with each other based on the radio resource stipulated by the system.

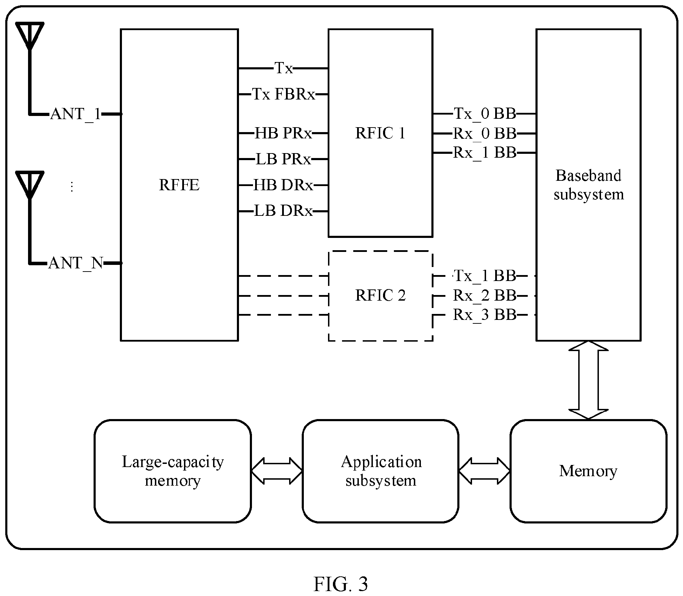

FIG. 3 is a schematic diagram of a structure of a communication apparatus according to an embodiment of this application. The communication apparatus may be the terminal or the base station in embodiments of this application. As shown in FIG. 3, the communication apparatus may include a plurality of components, for example, an application subsystem, a memory, a massive storage, a baseband subsystem, a radio frequency integrated circuit (RFIC), a radio frequency front-end (RFFE) component, and an antenna (ANT). These components may be coupled through various interconnection buses or in other electrical connection manners.

In FIG. 3, ANT_1 represents a first antenna, ANT_N represents an N^{th} antenna, and N is a positive integer greater than 1. Tx represents a transmitting path, and Rx represents a receiving path. Different numbers represent different paths. Each path may represent a signal processing channel. FBRx represents a feedback receiving path, PRx represents a primary receiving path, and DRx represents a diversity receiving path. HB represents a high band, LB represents a low band, and HB or LB indicates that a band is comparatively high or low. BB represents a baseband. It should be understood that marks and components in FIG. 3 are merely used for illustration, and are merely used as a possible implementation. This embodiment of this application further includes another implementation. For example, the communication apparatus may include more or fewer paths, and include more or fewer components.

The application subsystem may be used as a main control system or a main computing system of the communication apparatus, and is configured to: run a main operating system and an application program, manage software and hardware resources of the entire communication apparatus, and provide a user operation interface for a user. In addition, the application subsystem may further include driver software related to another subsystem (for example, the baseband subsystem).

The application subsystem may include one or more processors. A plurality of processors may be a plurality of processors of a same type, or may include a combination of a plurality of types of processors. In this application, the processor may be a processor for a general purpose, or may be a processor designed for a specific field. For example, the processor may be a central processing unit (CPU), a digital signal processor (DSP), or a micro control unit (MCU). Alternatively, the processor may be a graphics processing unit (GPU), an image signal processor (ISP), an audio signal processor (ASP), or an AI processor specially designed for an artificial intelligence (AI) application. The AI processor includes but is not limited to a neural network processing unit (NPU), a tensor processing unit (TPU), and a processor referred to as an AI engine.

In FIG. 3, a radio frequency integrated circuit (including an RFIC 1, and one or more optional RFICs 2) and a radio frequency front-end component may jointly form a radio frequency subsystem. According to different signal receiving or transmitting paths, the radio frequency subsystem may also be classified into a radio frequency receive channel (RF receive path) and a radio frequency transmit channel (RF transmit path). The radio frequency receive channel may receive a radio frequency signal by using an antenna, perform processing (for example, amplification, filtering, and down-conversion) on the radio frequency signal to obtain a baseband signal, and transfer the baseband signal to the baseband subsystem. The radio frequency transmit channel may receive a baseband signal from the baseband subsystem, perform processing (such as up-conversion, amplification, and filtering) on the baseband signal to obtain a radio frequency signal, and finally radiate the radio frequency signal to space by using an antenna. The radio frequency integrated circuit may be referred to as a radio frequency processing chip or a radio frequency chip.

Specifically, the radio frequency subsystem may include electronic components such as an antenna switch, an antenna tuner, a low noise amplifier (LNA), a power amplifier (PA), a frequency mixer, a local oscillator (LO), and a filter. The electronic components may be integrated into one or more chips based on a requirement. The radio frequency integrated circuit may be referred to as a radio frequency processing chip or a radio frequency chip. The radio frequency front-end component may also be an independent chip. The radio frequency chip is sometimes referred to as a receiver, a transmitter, or a transceiver. As technologies evolve, an antenna may sometimes be considered as a part of a radio frequency subsystem, and may be integrated into a chip of the radio frequency subsystem. The antenna, the radio frequency front-end component, and radio frequency chip can be manufactured and sold separately. Certainly, the radio frequency subsystem may use different components or different integration manners based on requirements for power consumption and performance. For example, the radio frequency front-end component is integrated into the radio frequency chip, or even both of the antenna and the radio frequency front-end component are integrated into the radio frequency chip, and the radio frequency chip may alternatively be referred to as a radio frequency antenna module or an antenna module.

The baseband subsystem processes a baseband signal, and a function of the baseband subsystem is similar to a function of the radio frequency subsystem, that is, processes a radio frequency signal. The baseband subsystem may extract useful information or data bits from the baseband signal, or convert information or data bits into a to-be-sent baseband signal. The information or the data bits may be data that represents user data or control information such as a voice, a text, or video. For example, the baseband subsystem may implement modulation and demodulation, encoding and decoding, and other signal processing operations. For different radio access technologies, for example, 5G NR and 4G LTE, baseband signal processing operations are not completely the same.

In addition, because a radio frequency signal is usually an analog signal, and a signal processed by the baseband subsystem is mainly a digital signal, an analog-to-digital conversion component is further required in the communication apparatus. In this embodiment of this application, the analog-to-digital conversion component may be disposed in the baseband subsystem, or may be disposed in the radio frequency subsystem. The analog-to-digital conversion component includes an analog-to-digital converter (ADC) that converts an analog signal into a digital signal, and a digital-to-analog converter (DAC) that converts a digital signal into an analog signal.

The baseband subsystem, similar to the application subsystem, may also include one or more processors. In addition, the baseband subsystem may further include one or more hardware accelerators (HAC). The hardware accelerator may be configured to specially complete some sub-functions with high processing overheads, for example, assembling and parsing a data packet, and encrypting and decrypting a data packet. The sub-functions may also be implemented by using a processor having a general function. However, due to performance or costs, it may be more proper to use the hardware accelerator to implement the sub-functions. In a specific implementation, the hardware accelerator is mainly implemented by using an application-specific integrated circuit (ASIC). Certainly, the hardware accelerator may alternatively include one or more relatively simple processors, for example, an MCU.

In embodiments of this application, the baseband subsystem and the radio frequency subsystem jointly form a communication subsystem, to provide a wireless communication function for the communication apparatus. Generally, the baseband subsystem is responsible for managing software and hardware resources of the communication subsystem, and may configure a working parameter of the radio frequency subsystem. The processor of the baseband subsystem may run a sub-operating system of the communication subsystem. The sub-operating system is usually an embedded operating system or a real time operating system, for example, a VxWorks operating system or a QuRT system of Qualcomm.

The baseband subsystem may be integrated into one or more chips, and the chip may be referred to as a baseband processing chip or a baseband chip. The baseband subsystem may be used as an independent chip, and the chip may be referred to as a modem or a modem chip. The baseband subsystem can be manufactured and sold by the modem chip. The modem chip is sometimes referred to as a baseband processor or a mobile processor. In addition, the baseband subsystem may be further integrated into a larger chip, and is manufactured and sold in a unit of a larger chip. The larger chip may be referred to as a system chip, a chip system, a system on a chip (SoC), or a SoC chip for short. Software components of the baseband subsystem may be built in the hardware component before the chip is delivered, may be imported from another non-volatile memory into the hardware component after the chip is delivered, or may be downloaded and updated online through a network.

In addition, the communication apparatus further includes a memory, for example, a memory and a mass storage in FIG. 3. In addition, the application subsystem and the baseband subsystem may further include one or more caches respectively. In a specific implementation, the memory may be classified into a volatile memory and a non-volatile memory (NVM). The volatile memory is a memory in which data stored in the memory is lost after a power supply is interrupted. Currently, volatile memories are mainly random access memories (RAM), including a static random access memory (SRAM) and a dynamic random access memory (DRAM). The non-volatile memory is a memory in which data stored in the memory is not lost even if a power supply is interrupted. Common non-volatile memories include a read-only memory (ROM), an optical disc, a magnetic disk, various memories based on a flash memory technology, and the like. Generally, a volatile memory may be used as the memory and the cache, and a non-volatile memory, for example, a flash memory, may be used as the mass storage.

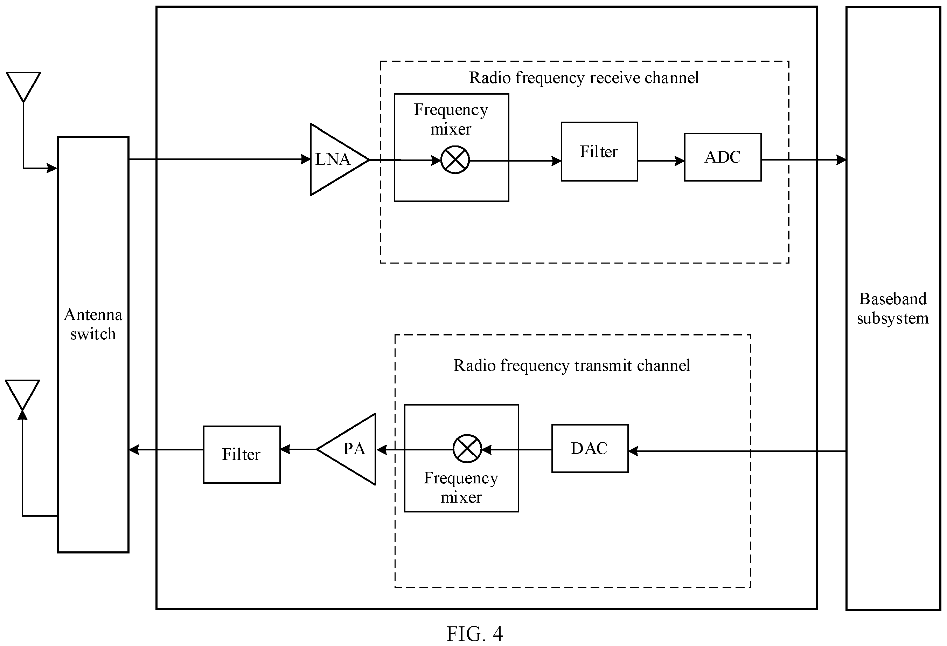

FIG. 4 is a schematic diagram of a structure of another communication apparatus according to an embodiment of this application. FIG. 4 shows some common components used for radio frequency signal processing in the communication apparatus. It should be understood that although FIG. 4 shows only one radio frequency receive channel and one radio frequency transmit channel, the communication apparatus in this embodiment of this application is not limited thereto. The communication apparatus may include one or more radio frequency receive channels and one or more radio frequency transmit channels. The radio frequency transmit channel may include modules such as a digital-to-analog converter (DAC) and a frequency mixer. Before an output signal of the radio frequency transmit channel is transmitted by an antenna, the output signal of the radio frequency transmit channel is further processed by using modules such as a PA and a filter. The radio frequency receive channel may include modules such as a frequency mixer, a filter, and an analog-to-digital converter (ADC). An antenna received by the radio frequency receive channel from an antenna may further be processed by modules such as a low noise amplifier (LNA). FIG. 4 is merely an example. Modules included in the radio frequency receive channel and the radio frequency transmit channel are not enumerated herein in this embodiment of this application.

It should be noted that an ET power module and a DPD core may be located in the radio frequency transmit channel, or may be located outside the radio frequency transmit channel.

### Embodiment 1

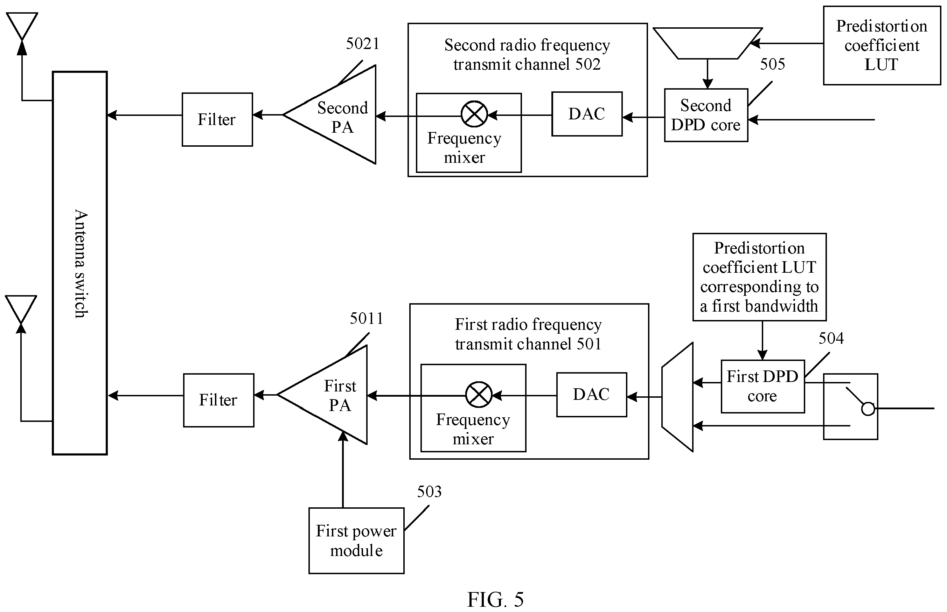

With reference to the foregoing description, FIG. 5 is a schematic diagram of a structure of a communication apparatus applicable to an embodiment of this application.

Refer to FIG. 5. The communication apparatus includes at least two radio frequency transmit channels: a first radio frequency transmit channel 501 and a second radio frequency transmit channel 502. The first radio frequency transmit channel 501 includes modules such as a frequency mixer and a DAC, and the second radio frequency transmit channel 502 includes modules such as a frequency mixer and a DAC.

In an actual application, the communication apparatus shown in FIG. 5 may be an RFIC, and the communication apparatus shown in FIG. 5 may be further connected to another external module, to receive and send a radio frequency signal. For example, in FIG. 5, an output end of the first radio frequency transmit channel 501 is connected to a first PA 5011, and the second radio frequency transmit channel 502 is connected to a second PA 5021. The first PA 5011 may be located on the first radio frequency transmit channel 501, or may be located outside the first radio frequency transmit channel 501. Correspondingly, the second PA 5021 may be located on the second radio frequency transmit channel 502, or may be located outside the second radio frequency transmit channel 502.

In this embodiment of this application, when the first PA amplifies a signal, the first PA 5011 needs to be powered by an external power supply to operate, and a voltage input end of the first PA 5011 may be further connected to a first power module 503, that is, the first power module 503 provides a power supply voltage for the first PA 5011. FIG. 5 further includes other modules, for example, a first DPD core 504 corresponding to the first radio frequency transmit channel and a second DPD core 505 corresponding to the second radio frequency transmit channel, and the modules are not enumerated herein.

In this embodiment of this application, an operating bandwidth of the first radio frequency transmit channel 501 is switched between a first bandwidth and a second bandwidth, and an operating bandwidth of the second radio frequency transmit channel 502 is the first bandwidth. The first bandwidth is not equal to the second bandwidth. For example, the first bandwidth may be greater than the second bandwidth.

For example, a center frequency of the first bandwidth is different from a center frequency of the second bandwidth. For example, the center frequency of the first bandwidth is 3.5 GHz, and the center frequency of the second bandwidth is 2.1 GHz. Certainly, the foregoing is merely an example. Specific values of the center frequency of the first bandwidth and the center frequency of the second bandwidth may be determined based on an actual situation, and examples are not enumerated herein.

It should be noted that the first radio frequency transmit channel 501 may perform bandwidth switching when the first radio frequency transmit channel 501 receives a bandwidth switching control instruction. Specifically, how to receive the control instruction and a specific format of the control instruction are not limited in this embodiment of this application.

For example, the communication apparatus is used in a super uplink (SU) scenario, and the first radio frequency transmit channel 501 may continuously and quickly switch, based on the control instruction, between a bandwidth whose center frequency is 3.5 GHz and a bandwidth whose center frequency is 2.1 GHz.

With reference to the foregoing descriptions, in this embodiment of this application, when the first radio frequency transmit channel 501 is switched between different bandwidths, the first PA 5011 may be compensated in different manners. In this way, predistortion coefficient LUTs corresponding to different bandwidths do not need to be loaded to the first DPD core 504 each time bandwidth switching is performed. Therefore, a switching latency is reduced, and working efficiency of the PA and linearity of the system are improved. For specific content of the predistortion coefficient LUT, refer to descriptions in the conventional technology. A specific implementation of the predistortion coefficient LUT is not limited in this embodiment of this application.

Specifically, with reference to FIG. 5, in this embodiment of this application, when the first radio frequency transmit channel 501 operates in the first bandwidth, the first DPD core 504 may output a signal on which digital predistortion processing is performed, to the first radio frequency transmit channel 501, and the first radio frequency transmit channel 501 processes the received signal to output a first signal. In other words, the first signal output by the first radio frequency transmit channel 501 is a signal on which digital predistortion processing is performed.

It should be noted that a predistortion coefficient LUT corresponding to the first bandwidth may be prestored in the first DPD core 504. When the first radio frequency transmit channel 501 operates in the first bandwidth, digital predistortion processing is performed on an input signal by using the predistortion coefficient LUT corresponding to the first bandwidth.

When the first radio frequency transmit channel 501 operates in the first bandwidth, the first radio frequency transmit channel 501 is configured to provide, for the first PA 5011, a signal on which digital predistortion processing is performed.

The first PA 5011 is configured to amplify a signal output by the first radio frequency transmit channel 501, that is, amplify the first signal.

Further, the first power module 503 is configured to provide a power supply voltage of a non-envelope waveform for the first PA, that is, a waveform of the power supply voltage of the first PA 5011 is a non-envelope waveform. For example, in this case, the first power module 503 may output a fixed voltage to supply power to the first PA 5011. In this case, a waveform of the power supply voltage of the first PA 5011 is a straight line, and the fixed voltage may be, for example, a rated power supply voltage of the first PA 5011. Alternatively, the first power module 503 may supply power to the first PA 5011 in an average power tracking (APT) manner. In this case, the power supply voltage of the first PA 5011 jumps between a plurality of voltages in different time periods, for example, jumps from 3 V to 5 V, and then jumps from 5 V to 4 V This depends on an actual situation.

When the first radio frequency transmit channel 501 operates in the second bandwidth, the first radio frequency transmit channel is configured to provide, for the first PA, a signal on which digital predistortion processing is not performed. Specifically, the first DPD core 504 is configured to be bypassed from the input end of the first PA 5011, and no longer performs digital predistortion processing on a radio frequency signal input to the first radio frequency transmit channel 501. The signal input to the first radio frequency transmit channel 501 is no longer processed by the first DPD core 504, that is, a second signal input to the first PA 5011 is a signal on which digital predistortion processing is not performed.

In this case, the first power module 503 is configured to provide, for the first PA 503, a power supply voltage of an envelope waveform, where a waveform of the power supply voltage provided by the first power module 503 is an envelope waveform. The first PA 5011 is configured to amplify a signal output by the first radio frequency transmit channel 501, that is, amplify the second signal.

It should be noted that, because the first power module 503 generates a power supply voltage by using an envelope tracking (ET) technology, the first power module 503 can provide a voltage of an envelope waveform. Specifically, an envelope tracking LUT corresponding to the first bandwidth may be prestored in the first power module 503. When the first radio frequency transmit channel 501 operates in the second bandwidth, the first power module 503 may generate, by using an envelope tracking LUT corresponding to the second bandwidth, a power supply voltage provided by the first PA 5011.

For specific content of the envelope tracking LUT, refer to descriptions in the conventional technology. A specific implementation of the envelope tracking LUT is not limited in this embodiment of this application.

Further, in this embodiment of this application, when the second radio frequency transmit channel 502 operates in the first bandwidth, the second DPD core 505 in the second radio frequency transmit channel 502 may be configured to perform digital predistortion processing on an input signal. The predistortion coefficient LUT corresponding to the first bandwidth may be prestored in the second DPD core 505, so that digital predistortion processing may be performed on an input signal by using the predistortion coefficient LUT corresponding to the first bandwidth.

Correspondingly, the second PA 5021 on the second radio frequency transmit channel 502 may be configured to amplify a signal on which the second DPD core 505 performs digital predistortion processing.

A fixed voltage, for example, a rated power supply voltage of the second PA 5021, may be used to supply power to the second PA 5021, an APT technology may be used to supply power to the second PA 5021, or an ET technology may be used to supply power to the second PA 5021.

According to the foregoing solution, when the first radio frequency transmit channel is switched between different bandwidths, nonlinear distortion of the first PA may be reduced in different manners when the first radio frequency transmit channel operates in different bandwidths, to ensure fast bandwidth switching and reduce non-linear distortion of the first PA on the first radio frequency transmit channel. Specifically, when the first radio frequency transmit channel operates in the first bandwidth, digital predistortion processing may be performed on an input signal of the first PA, and when the first radio frequency transmit channel operates in the second bandwidth, the power supply voltage of an envelope waveform is provided for the first PA. During bandwidth switching, an LUT required for digital predistortion processing does not need to be adjusted, and an LUT required for generating a power supply voltage of an envelope waveform does not need to be adjusted either. Therefore, fast bandwidth switching can be implemented, and energy efficiency of the first PA can also be ensured. In the foregoing solution, radio frequency channel linearization in an uplink high dynamic switching scenario can be implemented with minimum control overheads. In addition, the DPD core does not need to store all predistortion coefficient LUTs, and the ET power module does not need to store all envelope tracking LUTs either. Therefore, linearization performance of the system and sending efficiency of the system can be improved without increasing internal storage space of the DPD core and the ET power module.

### Embodiment 2

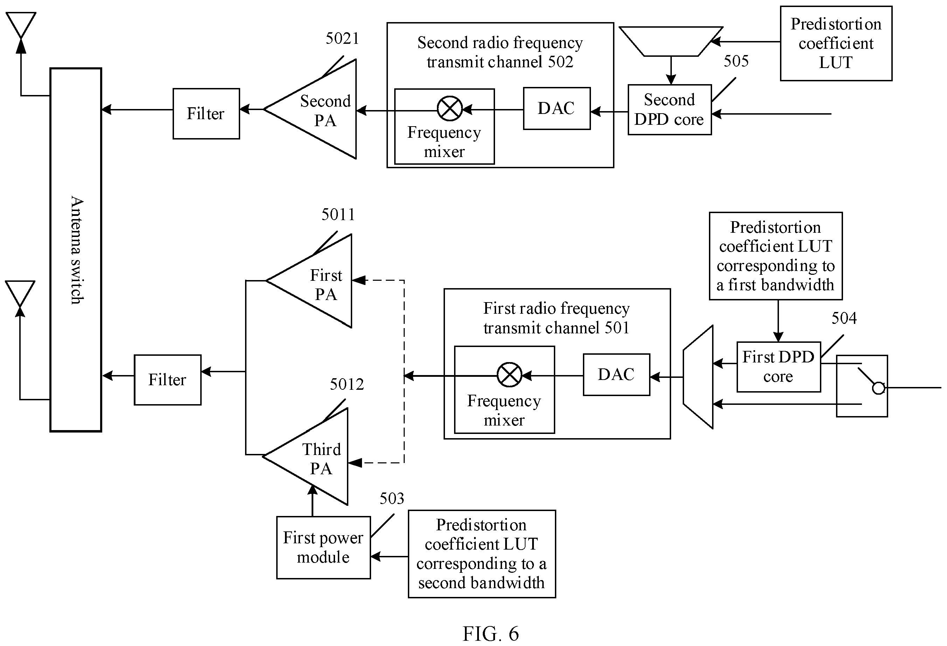

In FIG. 5, an output end of the first radio frequency transmit channel 501 is connected to one PA. In this embodiment of this application, the output end of the first radio frequency transmit channel 501 may further be selectively connected to two PAs. For details, refer to FIG. 6. Structures in FIG. 6 and FIG. 5 are similar, and a difference lies in that the output end of the first radio frequency transmit channel 501 in FIG. 6 is coupled to the first PA 5011 and a third PA 5012. A voltage input end of the third PA 5012 is connected to an output end of the first power module 503.

The first power module 503 may include a plurality of power modules, or may be an independent power module. When the first power module 503 includes a plurality of power modules, the first power module 503 may include a power module capable of providing a power supply voltage of an envelope waveform and a power module capable of providing a power supply voltage of a non-envelope waveform.

Specifically, when the first radio frequency transmit channel 501 operates in the first bandwidth, the first radio frequency transmit channel 501 is configured to provide, for the first PA 5011, a signal on which digital predistortion processing is performed, and the first power module 503 is configured to provide a power supply voltage of a non-envelope waveform for the first PA. The third PA 5012 is configured to be bypassed from an output end of the first radio frequency transmit channel 501, and the first PA 5011 is configured to be connected to the output end of the first radio frequency transmit channel 501. A waveform of the power supply voltage of the first PA 5011 is a non-envelope waveform. The first PA 5011 is configured to amplify a first signal output by the first radio frequency transmit channel 501, where the first signal is a signal on which digital predistortion processing is performed.

When the first radio frequency transmit channel 501 operates in the second bandwidth, the first radio frequency transmit channel is configured to provide, for the third PA, a signal on which digital predistortion processing is not performed. The third PA 5012 is configured to connect to the output end of the first radio frequency transmit channel 501, and the first PA 5011 is configured to bypass the output end of the first radio frequency transmit channel. The first power module 503 is configured to provide a power supply voltage for the third PA 5012, and a waveform of the power supply voltage provided by the first power module is an envelope waveform. The third PA 5012 is configured to amplify a second signal output by the first radio frequency transmit channel 501, where the second signal is a signal on which digital predistortion processing is not performed.

According to the foregoing solution, when the first radio frequency transmit channel operates in the first bandwidth, digital predistortion processing is performed on a radio frequency signal of the first radio frequency channel, to reduce non-linear distortion. When the first radio frequency transmit channel operates in the second bandwidth, although digital predistortion processing is not performed on the radio frequency signal of the first radio frequency channel, the third PA that amplifies an output signal supplies power by using the power supply voltage of the envelope waveform, to reduce non-linear distortion. In the foregoing solution, during bandwidth switching, an LUT required for digital predistortion processing does not need to be adjusted, and an LUT required for generating a power supply voltage of an envelope waveform does not need to be adjusted either. Therefore, fast bandwidth switching can be implemented, and non-linear distortion of an output signal of the first radio frequency transmit channel can also be reduced.

### Embodiment 3

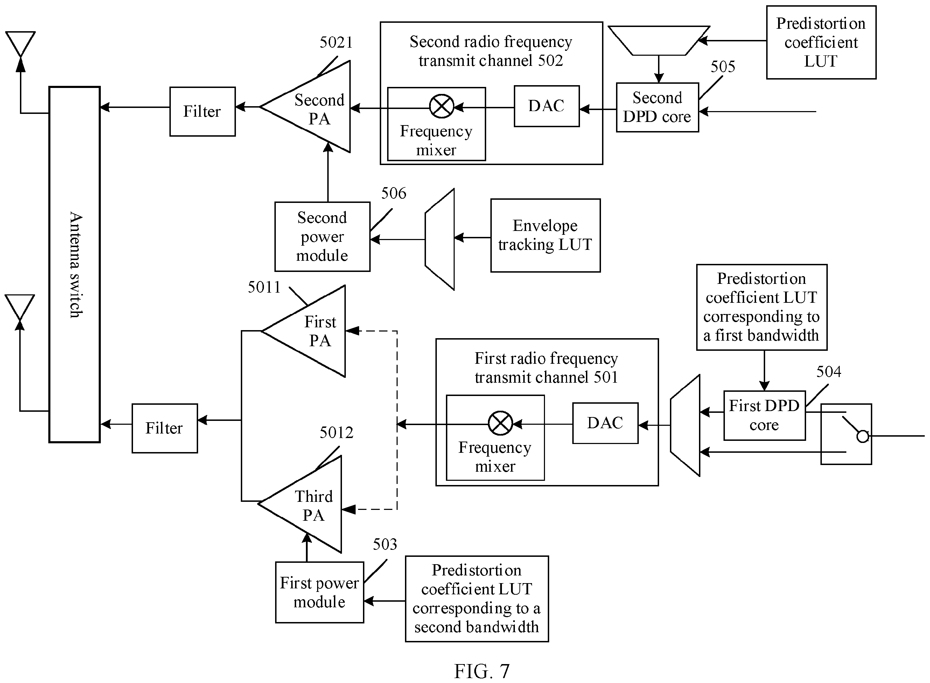

With reference to the foregoing description and FIG. 6, as shown in FIG. 7, when the second PA 5021 amplifies a signal, the second PA 5021 needs to be powered by an external power supply to operate, and a voltage input end of the second PA 5021 may further be connected to a second power module 506, that is, the second power module 506 provides a power supply voltage for the second PA 5021. A waveform of the power supply voltage provided by the second power module 506 is an envelope waveform.

It should be noted that, because the second power module 506 may generate the power supply voltage by using the ET technology, the second power module 506 can provide a voltage of the envelope waveform.

Specifically, an envelope tracking LUT corresponding to the first bandwidth may be prestored in the second power module 506. When the second radio frequency transmit channel 502 operates in the first bandwidth, the second power module 506 may generate, by using an envelope tracking LUT corresponding to the first bandwidth, a power supply voltage provided by the second PA 5021.

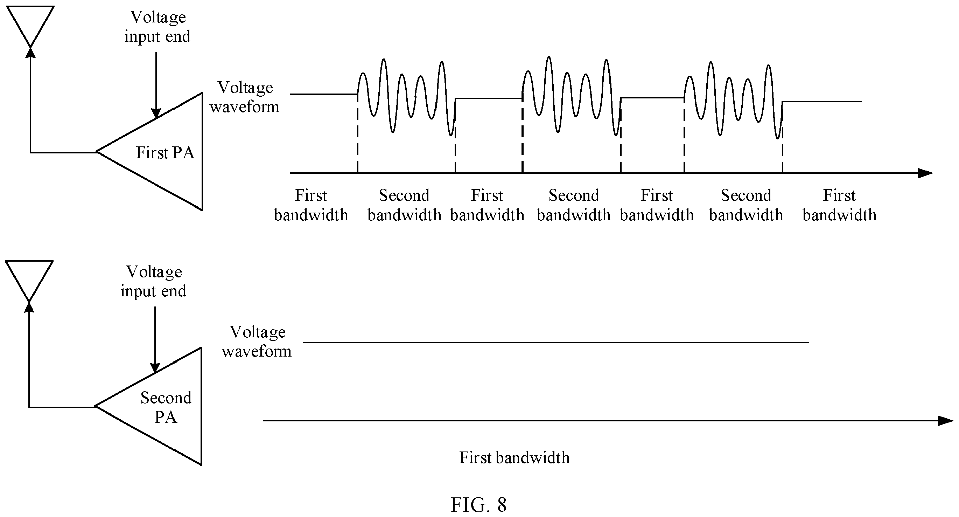

The foregoing embodiment describes how to process an output signal of the first radio frequency transmit channel 501 when the first radio frequency transmit channel 501 operates in different bandwidths. Further, with reference to the foregoing description, when the first radio frequency transmit channel 501 operates in the first bandwidth, a waveform of a voltage input by the voltage input end of the first PA 5011 is a straight line, that is, an input voltage is a fixed voltage, for example, 5 V When the first radio frequency transmit channel 501 operates in the second bandwidth, a voltage waveform input by the voltage input end of the first PA 5011 or the third PA 5012 is an envelope waveform, that is, an input voltage constantly changes. For details, refer to FIG. 8.

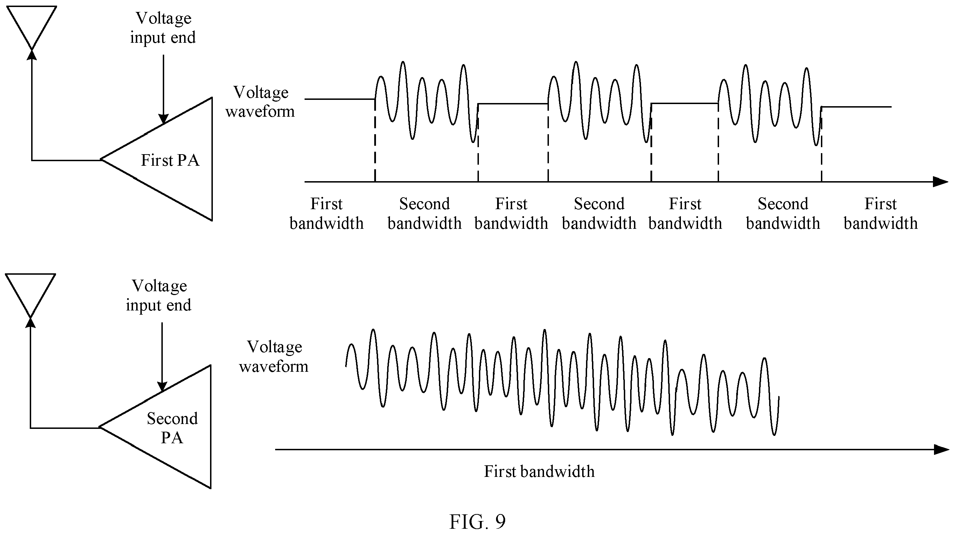

In FIG. 8, a waveform of a voltage input by the voltage input end of the second PA 5021 is further described. In FIG. 8, an example in which the voltage input by the voltage input end of the second PA 5021 is a fixed voltage is used for description. When the second power module 506 provides a power supply voltage for the second PA 5021, for a voltage input by the voltage input end of the second PA 5021, refer to FIG. 9.

It can be learned from FIG. 8 and FIG. 9 that a voltage waveform input by the voltage input end of the first PA 5011 is continuously switched between a fixed voltage and an envelope waveform as a bandwidth of the first radio frequency transmit channel 501 is switched. A waveform of the voltage input by the voltage input end of the second PA 5021 is a straight line in FIG. 8, and is an envelope waveform in FIG. 9.

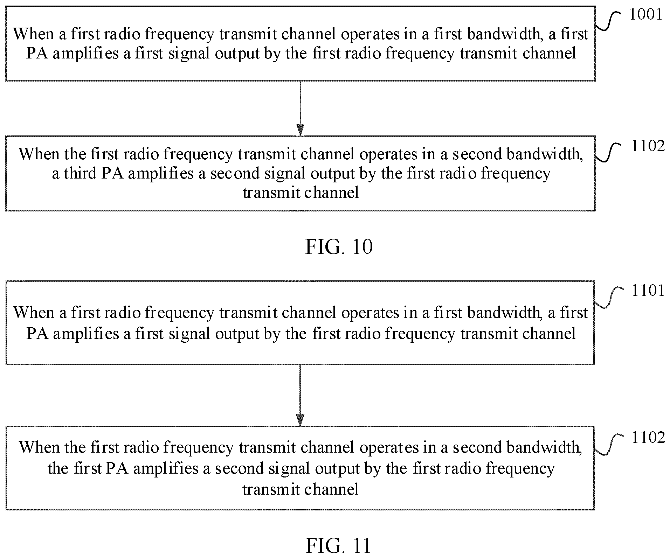

FIG. 10 is a schematic flowchart of a signal processing method according to an embodiment of this application. The method may be implemented by the communication apparatus that includes the first power module, the first PA, the third PA, and the first radio frequency transmit channel in the foregoing technical solution. The communication apparatus may be a terminal, or may be a base station. As shown in FIG. 10, the method may include the following steps.

Step 1001: When a first radio frequency transmit channel operates in a first bandwidth, the first PA amplifies a first signal output by the first radio frequency transmit channel.

The third PA is configured to be bypassed from the output end of the first radio frequency transmit channel, and the first PA is configured to be connected to the output end of the first radio frequency transmit channel. The first signal is a signal on which digital predistortion processing is performed, and a waveform of the power supply voltage of the first PA is a non-envelope waveform.

Step 1002: When the first radio frequency transmit channel operates in a second bandwidth, the third PA amplifies a second signal output by the first radio frequency transmit channel.

The third PA is configured to connect to the output end of the first radio frequency transmit channel, and the first PA is configured to bypass the output end of the first radio frequency transmit channel. The second signal is a signal on which no digital predistortion processing is performed, a power supply voltage of the third PA is provided by the first power module, a waveform of the power supply voltage provided by the first power module is an envelope waveform, and the first bandwidth is greater than the second bandwidth.

In an optional implementation, before the first PA amplifies a first signal, the method further includes: A first digital predistortion DPD core performs digital predistortion processing on a signal input to the first radio frequency transmit channel, to obtain the first signal.

In an optional implementation, before the first PA amplifies the second signal, the method further includes: configuring a first digital predistortion DPD core to be bypassed from an input end of the first PA.

In an optional implementation, a center frequency of the first bandwidth is different from a center frequency of the second bandwidth.

In an optional implementation, the center frequency of the first bandwidth is 3.5 GHz, and the center frequency of the second bandwidth is 2.1 GHz.

In an optional implementation, the communication apparatus further includes a second DPD core and a second radio frequency transmit channel, and the second radio frequency transmit channel includes a second PA. The method further includes: When the second radio frequency transmit channel operates in the first bandwidth, the second DPD core performs digital predistortion processing on a signal input to the second radio frequency transmit channel; and the second PA amplifies a signal on which digital predistortion processing is performed by the second DPD core.

In an optional implementation, the communication apparatus further includes a second power module, and the method further includes: The second power module provides a power supply voltage for the second PA, and a waveform of the power supply voltage provided by the second power module is an envelope waveform.

In a possible design, the first power module is a power module using an envelope tracking ET technology.

In a possible design, the second power module is a power module using an envelope tracking ET technology.

FIG. 11 is a schematic flowchart of a signal processing method according to an embodiment of this application. The method may be implemented by the communication apparatus that includes the first power module and the first radio frequency transmit channel in the foregoing technical solution. The communication apparatus may be a terminal, or may be a base station. As shown in FIG. 11, the method may include the following steps.

Step 1101: When a first radio frequency transmit channel operates in a first bandwidth, a first PA amplifies a first signal output by the first radio frequency transmit channel.

The first signal is a signal on which digital predistortion processing is performed, and a waveform of the power supply voltage of the first PA is a non-envelope waveform.

Step 1102: When the first radio frequency transmit channel operates in a second bandwidth, the first PA amplifies a second signal output by the first radio frequency transmit channel.

The second signal is a signal on which digital predistortion processing is not performed, a power supply voltage of the first PA is provided by the first power module, a waveform of the power supply voltage provided by the first power module is an envelope waveform, and the first bandwidth is greater than the second bandwidth.

In an optional implementation, before the first PA amplifies a first signal, the method further includes: A first digital predistortion DPD core performs digital predistortion processing on a signal input to the first radio frequency transmit channel, to obtain the first signal.

In an optional implementation, before the first PA amplifies the second signal, the method further includes: configuring a first digital predistortion DPD core to be bypassed from an input end of the first PA.

In an optional implementation, a center frequency of the first bandwidth is different from a center frequency of the second bandwidth.

In an optional implementation, the center frequency of the first bandwidth is 3.5 GHz, and the center frequency of the second bandwidth is 2.1 GHz.

In an optional implementation, the communication apparatus further includes a second DPD core and a second radio frequency transmit channel, and the second radio frequency transmit channel includes a second PA. The method further includes: When the second radio frequency transmit channel operates in the first bandwidth, the second DPD core performs digital predistortion processing on a signal input to the second radio frequency transmit channel; and the second PA amplifies a signal on which digital predistortion processing is performed by the second DPD core.

In an optional implementation, the communication apparatus further includes a second power module, and the method further includes: The second power module provides a power supply voltage for the second PA, and a waveform of the power supply voltage provided by the second power module is an envelope waveform.

In a possible design, the first power module is a power module using an envelope tracking ET technology.

In a possible design, the second power module is a power module using an envelope tracking ET technology.

A person skilled in the art should understand that embodiments of this application may be provided as a method, a system, or a computer program product. Therefore, this application may use a form of hardware only embodiments, software only embodiments, or embodiments with a combination of software and hardware. Moreover, this application may use a form of a computer program product that is implemented on one or more computer-usable storage media (including but not limited to a disk memory, an optical memory, and the like) that include computer-usable program code.

This application is described with reference to the flowcharts and/or block diagrams of the method, the device (system), and the computer program product according to this application. It should be understood that computer program instructions may be used to implement each process and/or each block in the flowcharts and/or the block diagrams and a combination of a process and/or a block in the flowcharts and/or the block diagrams. These computer program instructions may be provided for a general-purpose computer, a dedicated computer, an embedded processor, or a processor of any other programmable data processing device to generate a machine, so that the instructions executed by a computer or a processor of any other programmable data processing device generate an apparatus for implementing a specific function in one or more processes in the flowcharts and/or in one or more blocks in the block diagrams.

These computer program instructions may be stored in a computer-readable memory that can instruct the computer or any other programmable data processing device to operate in a specific manner, so that the instructions stored in the computer-readable memory generate an artifact that includes an instruction apparatus. The instruction apparatus implements a specific function in one or more processes in the flowcharts and/or in one or more blocks in the block diagrams.

It is clearly that, a person skilled in the art can make various modifications and variations to this application without departing from the scope of this application. This application is intended to cover these modifications and variations of this application provided that they fall within the scope of protection defined by the following claims and their equivalent technologies.

## Claims

1. A communication apparatus, comprising:
a first power module and a first radio frequency transmit channel, wherein the first radio frequency transmit channel and the first power module are separately coupled to a first power amplifier PA;
when the first radio frequency transmit channel operates in a first bandwidth, the first radio frequency transmit channel is configured to provide, for the first PA, a signal on which digital predistortion processing is performed, and the first power module is configured to provide, for the first PA, a power supply voltage of a non-envelope waveform; and
when the first radio frequency transmit channel operates in a second bandwidth, the first radio frequency transmit channel is configured to provide, for the first PA, a signal on which digital predistortion processing is not performed, and the first power module is configured to provide, for the first PA, a power supply voltage of an envelope waveform.

2. A communication apparatus, comprising:
a first power module and a first radio frequency transmit channel, wherein the first radio frequency transmit channel and the first power module are separately coupled to a first power amplifier PA and a third PA;
when the first radio frequency transmit channel operates in a first bandwidth, the first radio frequency transmit channel is configured to provide, for the first PA, a signal on which digital predistortion processing is performed, and the first power module is configured to provide, for the first PA, a power supply voltage of a non-envelope waveform; and
when the first radio frequency transmit channel operates in a second bandwidth, the first radio frequency transmit channel is configured to provide, for the third PA, a signal on which digital predistortion processing is not performed, and the first power module is configured to provide, for the third PA, a power supply voltage of an envelope waveform.

3. The apparatus according to claim 1 or 2, wherein the apparatus further comprises a first digital predistortion DPD core;
when the first radio frequency transmit channel operates in the first bandwidth, the first DPD core is configured to perform digital predistortion processing on a signal input to the first radio frequency transmit channel; and
when the first radio frequency transmit channel operates in the second bandwidth, the first DPD core is configured to be bypassed from an input end of the first PA.

4. The apparatus according to claim 3, wherein the first DPD core performs, by using a predistortion coefficient lookup table LUT corresponding to the first bandwidth, digital predistortion processing on the signal input to the first radio frequency transmit channel.

5. The apparatus according to any one of claims 1 to 4, wherein when the first radio frequency transmit channel operates in the second bandwidth, the first power module generates, by using an envelope tracking LUT corresponding to the second bandwidth, a power supply voltage provided for the first PA or the third PA.

6. The apparatus according to any one of claims 1 to 5, wherein a center frequency of the first bandwidth is different from a center frequency of the second bandwidth.

7. The apparatus according to any one of claims 1 to 6, wherein the center frequency of the first bandwidth is 3.5 GHz, and the center frequency of the second bandwidth is 2.1 GHz.

8. The apparatus according to any one of claims 1 to 7, wherein the apparatus further comprises a second DPD core, a second radio frequency transmit channel, and a second PA;
when the second radio frequency transmit channel operates in the first bandwidth, the second DPD core is configured to perform digital predistortion processing on a signal input to the second radio frequency transmit channel; and
the second radio frequency transmit channel is configured to provide, for the second PA, a signal on which digital predistortion processing is performed.

9. The apparatus according to claim 8, wherein the apparatus further comprises a second power module; and the second power module is configured to provide a power supply voltage for the second PA, and a waveform of the power supply voltage provided by the second power module is an envelope waveform.

10. The apparatus according to any one of claims 1 to 9, wherein the first bandwidth is greater than the second bandwidth.

11. A signal processing method, applied to a communication apparatus, comprising a first power module and a first radio frequency transmit channel, wherein the first radio frequency transmit channel and the first power module are separately coupled to a first power amplifier PA, and the method comprises:
when the first radio frequency transmit channel operates in a first bandwidth, outputting, to the first PA by using the first radio frequency transmit channel, a signal on which digital predistortion processing is performed, and providing, for the first PA by using the first power module, a power supply voltage of a non-envelope waveform; and
when the first radio frequency transmit channel operates in a second bandwidth, providing, for the first PA by using the first radio frequency transmit channel, a signal on which digital predistortion processing is not performed, and providing, for the first PA by using the first power module, a power supply voltage of an envelope waveform.

12. A signal processing method, applied to a communication apparatus, comprising a first power module and a first radio frequency transmit channel, wherein the first radio frequency transmit channel and the first power module are separately coupled to a first power amplifier PA and a third PA, and the method comprises:
when the first radio frequency transmit channel operates in a first bandwidth, providing, for the first PA by using the first radio frequency transmit channel, a signal on which digital predistortion processing is performed, and providing, for the first PA by using the first power module, a power supply voltage of a non-envelope waveform; and
when the first radio frequency transmit channel operates in a second bandwidth, providing, for the third PA by using the first radio frequency transmit channel, a signal on which digital predistortion processing is not performed, and providing, for the third PA by using the first power module, a power supply voltage of an envelope waveform.

13. The method according to claim 11 or 12, wherein the communication apparatus further comprises a first digital predistortion DPD core; and
when the first radio frequency transmit channel operates in the first bandwidth, performing, by using the first DPD core, digital predistortion processing on a signal input to the first radio frequency transmit channel.

14. The method according to claim 13, wherein the first DPD core performs, by using a predistortion coefficient lookup table LUT corresponding to the first bandwidth, digital predistortion processing on the signal input to the first radio frequency transmit channel.

15. The method according to any one of claims 11 to 14, wherein a center frequency of the first bandwidth is different from a center frequency of the second bandwidth.

16. The method according to any one of claims 11 to 15, wherein the center frequency of the first bandwidth is 3.5 GHz, and the center frequency of the second bandwidth is 2.1 GHz.

17. The method according to any one of claims 11 to 16, wherein the communication apparatus further comprises a second DPD core, a second radio frequency transmit channel, and a second PA;
when the second radio frequency transmit channel operates in the first bandwidth, performing, by using the second DPD core, digital predistortion processing on a signal input to the second radio frequency transmit channel;
outputting, to the second PA by using the second radio frequency transmit channel, a signal on which digital predistortion processing is performed; and
providing, for the first PA by using the first power module, a power supply voltage of a non-envelope waveform, and performing, by using the second PA, amplification processing on the signal on which digital predistortion processing is performed.

18. The method according to claim 17, wherein the communication apparatus further comprises a second power module; and
providing, for the second PA, a power supply voltage by using the second power module, wherein a waveform of the power supply voltage provided by the second power module is an envelope waveform.

19. The method according to any one of claims 11 to 18, wherein the first bandwidth is greater than the second bandwidth.

20. A communication apparatus, comprising:
a processor and a memory, wherein
the memory is configured to store program instructions; and
the processor is configured to execute the program instructions stored in the memory, to implement the method according to any one of claims 11 to 19.

21. A communication apparatus, comprising:
a processor and an interface circuit, wherein
the interface circuit is configured to access a memory, and the memory stores program instructions; and
the processor is configured to: access the memory by using the interface circuit, and execute the program instructions stored in the memory, to implement the method according to any one of claims 11 to 19.

22. A computer-readable storage medium, wherein the computer-readable storage medium stores program code, and when the program code is executed by a computer, the method according to any one of claims 11 to 19 is implemented.

23. A computer program product, wherein when program code comprised in the computer program product is executed by a computer, the method according to any one of claims 11 to 19 is implemented.
